# EUROPEAN PATENT APPLICATION

(11) **EP 4 757 078 A1**
(43) Date of publication of application: **10.06.2026**
(21) Application number: 25221598.3
(22) Date of filing: 08.12.2025
(51) Int. Cl.: H01R 4/48, H01R 43/00

(54) **MAINTENANCE TOOL AND METHOD OF ACCESSING POWER CABLES IN A POWER DISTRIBUTION ASSEMBLY**

(30) Priority: 06.12.2024 IN 202421096558
(71) Applicant: Vertiv Corporation, Westerville, OH 43082 (US)
(72) Inventor: PANDITKAR, Rupesh Gajanan, 444505 Washim (IN); PATIL, Vinayak, 416211 Tal- Radhanagiri, Dist Kolhapur (IN); VICHARE, Omkar Suresh, 416701 Tal- Lanja, Dist Ratnagiri (IN)
(74) Representative: Cousens, Nico

(57) **Abstract**

A maintenance tool **200** and a method of accessing power cables in a power distribution assembly **100** is disclosed. A handle **202** configured for single-handed ergonomic operation and including an electrically insulated exterior surface. A bracket **204** mechanically coupled to the handle. The bracket having a specialized cutout configured to support and stabilize one or more power cables **102** while reducing mechanical stress on a circuit breaker terminal **302** of a circuit breaker of the power distribution assembly **100.** A locking mechanism **204** integrated within the maintenance tool and operable through the handle **202** to engage or disengage the one or more power cables **102** from the circuit breaker terminal **302.** The bracket positions the one or more power cables in a stable orientation, and the locking mechanism, in coordination with the bracket, operates to selectively secure or release the one or more power cables from the circuit breaker terminal.

## Description

### TECHNICAL FIELD

The present disclosure generally relates to the field of electrical maintenance tools, and more particularly to a maintenance tool and method of accessing power cables in a power distribution assembly.

### BACKGROUND

In power distribution assemblies, accessing and managing power cables can be a complex and time-consuming task, particularly in confined or hard-to-reach areas. Traditional methods often require the use of multiple tools to install, remove, or adjust cables, leading to inefficiency and increased risk of damage to components. Additionally, handling heavy cables and working near circuit breakers can place mechanical stress on terminals, complicating maintenance and repair processes, and requiring frequent disassembly of components.

### SUMMARY

This summary is provided to introduce aspects related to a maintenance tool and a method of accessing power cables in power distribution assembly. The maintenance tool provides an efficient and ergonomic solution for installing, removing, and adjusting power cables, particularly in confined spaces. The maintenance tool reduces the need for multiple devices, enhances safety by minimizing mechanical stress on circuit breaker terminals, and allows for single-handed operation, thereby improving the overall maintenance process and reducing downtime in power distribution systems.

In an aspect, a maintenance tool for accessing power cables in a power distribution assembly is disclosed. The maintenance tool may include a handle configured for single-handed ergonomic operation and including an electrically insulated exterior surface. The maintenance tool may further include a bracket mechanically coupled to the handle, the bracket having a specialized cutout configured to support and stabilize one or more power cables while reducing mechanical stress on a circuit breaker terminal of a circuit breaker of the power distribution assembly. The maintenance tool may further include a locking mechanism integrated within the maintenance tool and operable through the handle to engage or disengage the one or more power cables from the circuit breaker terminal. The handle, the bracket, and the locking mechanism cooperatively enable installation, removal, and adjustment of the one or more power cables in the circuit breaker terminal without requiring removal of the circuit breaker. The bracket positions the one or more power cables in a stable orientation, and the locking mechanism, in coordination with the bracket, operates to selectively secure or release the one or more power cables from the circuit breaker terminal, thereby ensuring secure engagement or disengagement of the one or more power cables from the circuit breaker terminal.

In another aspect, a method of accessing power cables in a power distribution assembly. The method may include providing a maintenance tool for accessing one or more power cables. The maintenance tool may include a handle configured for single-handed ergonomic operation and including an electrically insulated exterior surface. The maintenance tool may further include a bracket mechanically coupled to the handle, the bracket having a specialized cutout configured to support and stabilize the one or more power cables while reducing mechanical stress on a circuit breaker terminal of a circuit breaker in the power distribution assembly. The maintenance tool may further include a locking mechanism integrated within the maintenance tool and operable through the handle to engage or disengage the one or more power cables from the circuit breaker terminal. The method may further include positioning the handle, the bracket, and the locking mechanism relative to the circuit breaker such that the handle and the bracket cooperatively enable installation, removal, and adjustment of the one or more power cables in the circuit breaker terminal without requiring removal of the circuit breaker. The bracket positions the one or more power cables in a stable orientation, and the locking mechanism, in coordination with the bracket, operates to selectively secure or release the one or more power cables from the circuit breaker terminal, thereby ensuring secure engagement or disengagement of the one or more power cables from the circuit breaker terminal.

In another aspect, a system comprising: one or more power cables; a circuit breaker comprising a circuit breaker terminal; and, a maintenance tool of any preceding claim.

Other aspects and advantages of the disclosure will become apparent from the following description, taken in conjunction with the accompanying drawings, illustrating by way of example the principles of the disclosure.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**FIG. 1** illustrates a conventional setup where multiple power cables are routed through a power distribution assembly.
**FIG. 2** illustrates a perspective view of a maintenance tool.
**FIG. 3** depicts the maintenance tool accessing the power cables in a power distribution assembly.
**FIG. 4** is a flowchart of a method of accessing power cables in the power distribution assembly using the maintenance tool.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### LIST OF REFERENCE NUMERALS

**100** - Power Distribution Assembly
**102** - Power Cables
**200** - Maintenance Tool
**202** - Handle
**204** - Bracket
**206** - Locking Mechanism
**302** - Circuit Breaker Terminal

### DESCRIPTION

Illustrative embodiments are described with reference to the accompanying drawings. Wherever convenient, the same reference numbers are used throughout the drawings to refer to the same or like parts. While examples and features of disclosed principles are described herein, modifications, adaptations, and other implementations are possible without departing from the scope of the disclosed embodiments. It is intended that the following detailed description be considered as exemplary only, with the true scope being indicated by the following claims.

In power distribution assemblies, accessing and managing power cables can be a challenging and time-consuming task, especially in confined spaces. Traditional methods often require multiple tools for cable installation, removal, and adjustment, leading to inefficiency, increased risk of damage to the components, and operator fatigue. Furthermore, the mechanical stress on the circuit breaker terminals from heavy cables can result in system failures or damage during maintenance operations. These challenges make servicing power distribution assemblies both difficult and inefficient, increasing downtime and the likelihood of operational issues.

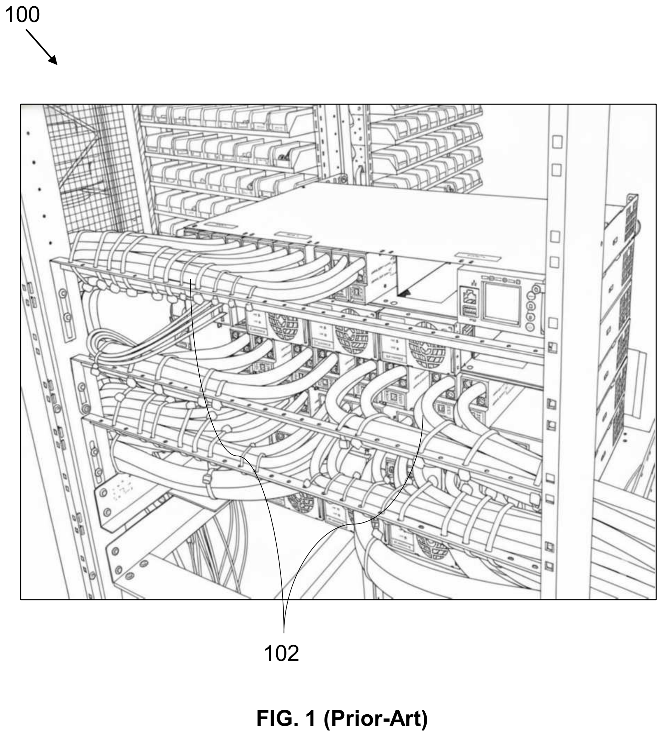

The present disclosure addresses these challenges by providing a maintenance tool designed for accessing and managing power cables in power distribution assemblies. The tool features an ergonomically designed handle for single-handed operation, a bracket that stabilizes and supports the cables, and a locking mechanism for securely engaging or disengaging the power cables from the circuit breaker terminal. These elements work together to enable efficient cable handling, reducing the need for multiple tools, minimizing strain on the circuit breaker terminals, and allowing for quick, safe, and easy maintenance without the need to remove the circuit breaker. The adjustability of the bracket and the quick-release feature of the locking mechanism provide added flexibility and ease of use, ensuring the tool can be applied in various power distribution setups, improving overall efficiency and safety during maintenance tasks. The present disclosure, along with these and other aspects, will now be described in detail with reference to **FIG. 1** through **FIG. 4****.**

**FIG. 1** illustrates a conventional setup where multiple power cables **102** are routed through a power distribution assembly 100, connecting various components such as circuit breakers, terminals, and other electrical infrastructure. In conventional power distribution assemblies, these power cables **102** are often densely packed and routed in hard-to-reach areas, making maintenance and adjustments difficult and time-consuming.

The challenge with this traditional arrangement is that the power cables **102** are often tightly clustered, which complicates access to specific components such as the circuit breaker terminals. In many cases, service personnel are required to use multiple tools and may have to disassemble parts of the power distribution assembly **100** or lift the circuit breakers to properly manage the power cables **102.** This process not only increases the complexity and time required for maintenance but also raises the risk of damaging the circuit breaker terminals or other components due to mechanical stress, improper handling, or accidental disconnections.

Additionally, the confined spaces in which the power cables **102** are routed increase the difficulty of performing maintenance safety and efficiently. Without a proper tool for quick and effective cable handling, service personnel may struggle to complete necessary tasks, leading to longer downtime and potential operational disruptions.

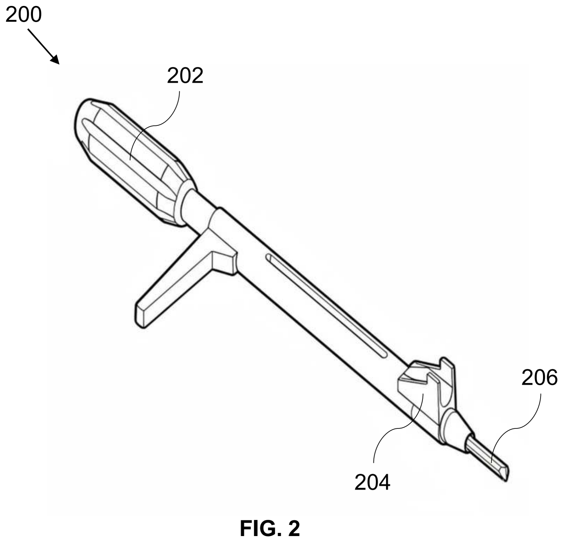

**FIG. 2** illustrates a perspective view of a maintenance tool **200.** The maintenance tool **200** may include a handle **202** configured for single-handed ergonomic operation and including an electrically insulated exterior surface.

The maintenance tool **200** may further include a bracket **204** mechanically coupled to the handle **202.** The bracket **204** having a specialized cutout configured to support and stabilize the power cables **102** while reducing mechanical stress on a circuit breaker terminal of a circuit breaker of the power distribution assembly **100.** The specialized cutout of the bracket **204** may be shaped to receive the power cables **102** of multiple diameters and maintain axial alignment during tightening or loosening operations. The bracket **204** may be adjustably mounted relative to the handle to accommodate circuit breakers of varying dimensions and orientations.

The maintenance tool **200** may further include a locking mechanism **206** integrated within the maintenance tool **200** and operable through the handle **202** to engage or disengage the power cables **102** from the circuit breaker terminal. The locking mechanism **206** may include a pressing screw or cam element configured to selectively secure or release the power cables **102** using a single-handed motion applied to the handle **202**. The locking mechanism **206** may further include a quick-release element configured to disengage the power cables **102** from the circuit breaker terminal without displacing the bracket **204** or the handle **202**.

The handle **202**, the bracket **204**, and the locking mechanism **206** cooperatively enable installation, removal, and adjustment of the power cables **102** in the circuit breaker terminal without requiring removal of the circuit breaker. The bracket **204** positions the power cables **102** in a stable orientation, and the locking mechanism **206**, in coordination with the bracket **204**, operates to selectively secure or release the power cables **102** from the circuit breaker terminal, thereby ensuring secure engagement or disengagement of the power cables **102** from the circuit breaker terminal.

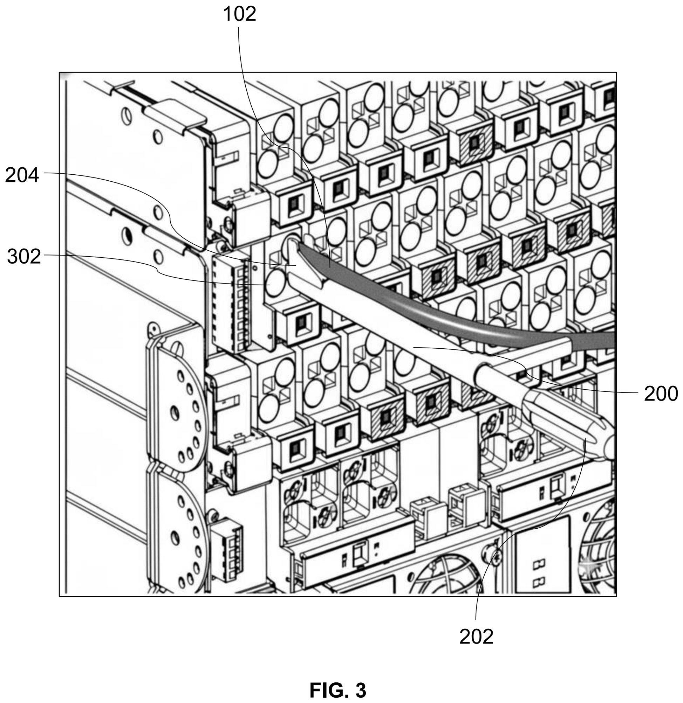

**FIG. 3** depicts the maintenance tool **200** accessing the power cables **102** in the power distribution assembly **100**. In this figure, the maintenance tool **200** is shown in operational use, with the handle **202**, the bracket **204,** and the locking mechanism **206** interacting to manage the power cables. The bracket **204**, mechanically coupled to the handle **202**, includes a specialized cutout that supports and stabilizes the power cables **102** while reducing mechanical stress on a circuit breaker terminal in the power distribution assembly **100**. The cutout of the bracket **204** is designed to receive the power cables **102** of varying diameters and maintain their axial alignment during tightening or loosening operations, ensuring precise cable management in tight spaces.

As shown in **FIG. 3****,** the locking mechanism **206** integrated within the tool enables secure engagement or disengagement of the power cables **102** from the circuit breaker terminal **302.** The locking mechanism **206** includes a pressing screw or cam element that allows for single-handed operation of the tool. The quick-release feature further enhances the tool's efficiency by enabling the power cables **102** to be quickly disengaged from the circuit breaker terminal **302** without displacing the bracket **204** or the handle **202**. The handle **202**, the bracket **204**, and the locking mechanism **206** together enable the installation, removal, and adjustment of power cables **102** without the need for circuit breaker removal, facilitating faster and safer maintenance in power distribution systems.

In a power distribution assembly **100** of a data center, service personnel need to perform routine maintenance on the power cables **102** that connect to various circuit breaker terminals **302**. The circuit breaker assembly is located in a confined rack space, with the cables **102** tightly routed and difficult to access. To facilitate the maintenance process, the technician uses the maintenance tool **200**, which includes the handle **202**, the bracket **204**, and the locking mechanism **206**. The technician begins by positioning the handle **202** of the maintenance tool **200** over the power distribution assembly **100**, ensuring the bracket **204** is aligned with the power cables **102**.

The bracket **204**, which has a specialized cutout, supports and stabilizes the power cables **102** as the technician adjusts the tool's position. The cutout is designed to accommodate cables of varying diameters, ensuring that regardless of cable size, the cables are aligned and properly supported, thereby reducing any risk of damage to the circuit breaker terminal **302**. Next, the technician uses the locking mechanism **206**, which is integrated into the handle **202**. By applying a single-handed motion, the technician engages the locking mechanism **206**, securing the power cables **102** in place. The pressing screw or cam element of the mechanism ensures that the cables are held firmly against the circuit breaker terminal **302**, preventing accidental disconnections.

The technician then adjusts the power cables **102** using the maintenance tool **200** to either install new cables, remove old ones, or reposition the cables for optimal performance. During this operation, the quick-release element of the locking mechanism **206** comes into play. When the technician needs to disengage the power cables **102**, they simply trigger the quick-release function, which allows for the rapid and secure detachment of the cables from the circuit breaker terminal **302,** all without moving the bracket **204** or handle **202**. Once the maintenance task is completed, the technician repositions the bracket **204** and the locking mechanism **206** as needed and finishes securing the power cables **102** in place. The entire operation is completed efficiently, without the need to remove the circuit breaker from the assembly, reducing downtime and improving the speed and safety of the maintenance procedure.

Once the maintenance task is completed, the technician repositions the bracket **204** and locking mechanism **206** as needed and finishes securing the power cables **102** in place. The entire operation is completed efficiently, without the need to remove the circuit breaker from the power distribution assembly **100**, thereby reducing downtime and improving the speed and safety of the maintenance procedure.

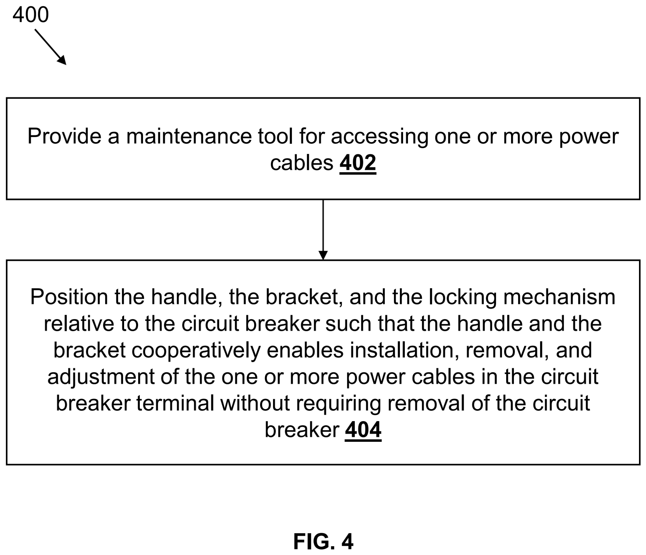

**FIG. 4** is a flowchart **400** of a method of accessing power cables in the power distribution assembly using the maintenance tool.

At step **402,** a maintenance tool is provided for accessing one or more power cables. The maintenance tool includes a handle configured for single-handed ergonomic operation, with an electrically insulated exterior surface. The tool also includes a bracket mechanically coupled to the handle. The bracket features a specialized cutout designed to support and stabilize the power cables, while reducing mechanical stress on a circuit breaker terminal in the power distribution assembly. Additionally, the maintenance tool incorporates a locking mechanism operable through the handle to engage or disengage the power cables from the circuit breaker terminal.

At step **404,** the handle, the bracket, and the locking mechanism are positioned relative to the circuit breaker such that they cooperatively enable the installation, removal, and adjustment of the power cables in the circuit breaker terminal without requiring removal of the circuit breaker. The bracket ensures that the power cables are positioned in a stable orientation, while the locking mechanism, in coordination with the bracket, operates to selectively secure or release the power cables from the circuit breaker terminal, thereby ensuring secure engagement or disengagement of the power cables from the circuit breaker terminal.

Thus, the disclosed maintenance tool and the method overcome the technical limitations of conventional power cable management systems by providing a maintenance tool integrating a single-handed ergonomic handle, an adjustable bracket with a specialized cutout for stabilizing cables, and a locking mechanism that securely engages or disengages the cables from the circuit breaker terminal. This integration allows for efficient cable installation, removal, and adjustment without the need for circuit breaker removal, reducing downtime, enhancing safety, and improving the overall effectiveness of maintenance operations in power distribution assemblies.

The methods, systems, devices, graphs, and/or tables discussed herein are examples. Various embodiments may omit, substitute, or add various procedures or components as appropriate. For instance, in alternative embodiments, the methods may be performed in an order different from that described, and/or various stages may be added, omitted, and/or combined. Also, features described with respect to certain embodiments may be combined in various other embodiments. Different aspects and elements of the embodiments may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

While illustrative and presently preferred embodiments of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as limitation on the scope of the disclosure.

## Claims

1. A maintenance tool (200) for accessing power cables (102) in a power distribution assembly (100), the maintenance tool (200) comprising:
a handle (202) including an electrically insulated exterior surface;
a bracket (204) mechanically coupled to the handle (202), the bracket (204) having a cutout configured to support and stabilize one or more power cables (102); and
a locking mechanism (206) integrated within the maintenance tool (200) and operable through the handle (202) to engage or disengage the one or more power cables (102) from a circuit breaker terminal (302),
wherein the handle (202), the bracket (204), and the locking mechanism (206) cooperatively enable installation, removal, and adjustment of the one or more power cables (102) in the circuit breaker terminal (302) without requiring removal of a circuit breaker, and
wherein the bracket (204) positions the one or more power cables (102) in a stable orientation, and the locking mechanism (206), in coordination with the bracket (204), operates to selectively secure or release the one or more power cables (102) from the circuit breaker terminal (302), thereby ensuring secure engagement or disengagement of the one or more power cables (102) from the circuit breaker terminal (302).

2. The maintenance tool (200) of claim 1, wherein the bracket (204) is adjustably mounted relative to the handle (202) to accommodate circuit breakers of varying dimensions and orientations.

3. The maintenance tool (200) of claim 1 or 2, wherein the cutout of the bracket (204) is shaped to receive power cables of multiple diameters and maintain axial alignment during tightening or loosening operations.

4. The maintenance tool (200) of any preceding claim, wherein the locking mechanism (206) comprises a pressing screw or cam element configured to selectively secure or release the one or more power cables (102) using a single-handed motion applied to the handle (202).

5. The maintenance tool (200) of any preceding claim, wherein the locking mechanism (206) further comprises a quick-release element configured to disengage the one or more power cables (102) from the circuit breaker terminal (206) without displacing the bracket (204) or the handle (202).

6. The maintenance tool (200) of any preceding claim, wherein the cutout of the bracket reduces mechanical stress on the circuit breaker terminal (302) of the circuit breaker of the power distribution assembly.

7. The maintenance tool (200) of any preceding claim, wherein the handle is configured for single-handed ergonomic operation.

8. A system comprising:
one or more power cables;
a circuit breaker comprising a circuit breaker terminal; and
a maintenance tool of any preceding claim.

9. A method (400) of accessing power cables (102) in a power distribution assembly (100), the method (400) comprising:
providing a maintenance tool (200) for accessing one or more power cables (102), wherein the maintenance tool (200) comprising:
a handle (202) including an electrically insulated exterior surface,
a bracket (204) mechanically coupled to the handle (202), the bracket (204) having a cutout configured to support and stabilize the one or more power cables (102), and
a locking mechanism (206) integrated within the maintenance tool (200) and operable through the handle (202) to engage or disengage the one or more power cables (102) from the circuit breaker terminal (302); and
positioning the handle (202), the bracket (204), and the locking mechanism (206) relative to the circuit breaker such that the handle (202) and the bracket (204) cooperatively enable installation, removal, and adjustment of the one or more power cables (102) in the circuit breaker terminal (302) without requiring removal of the circuit breaker,
wherein the bracket (204) positions the one or more power cables (102) in a stable orientation, and the locking mechanism (206), in coordination with the bracket (204), operates to selectively secure or release the one or more power cables (102) from the circuit breaker terminal (302), thereby ensuring secure engagement or disengagement of the one or more power cables (102) from the circuit breaker terminal (302).

10. The method (400) of claim 9, wherein the bracket (204) is adjustably mounted relative to the handle (202) to accommodate circuit breakers of varying dimensions and orientations.

11. The method (400) of claim 9 or 10, wherein the cutout of the bracket (204) is shaped to receive power cables (102) of multiple diameters and maintain axial alignment during tightening or loosening operations.

12. The method (400) of any of claims 9 to 11, wherein the locking mechanism (206) comprises a pressing screw or cam element configured to selectively secure or release the one or more power cables (102) using a single-handed motion applied to the handle (202).

13. The method (400) of any of claims 9 to 12, wherein the locking mechanism (204) further comprises a quick-release element configured to disengage the one or more power cables (102) from the circuit breaker terminal (302) without displacing the bracket (204) or the handle (202).

14. The method of any of claims 9 to 13, wherein the handle is configured for single-handed ergonomic operation.

15. The method of any of claims 9 to 14, wherein the cutout of the bracket reduces mechanical stress on the circuit breaker terminal of the circuit breaker of the power distribution assembly.
